# DEMANDE DE BREVET EUROPEEN

(11) **EP 1 607 979 A2**
(43) Date de publication de la demande: **21.12.2005**
(21) Numéro de dépôt: 05291195.5
(22) Date de dépôt: 03.06.2005
(51) Int. Cl.: G11C 7/18, G11C 11/16, G11C 8/10

(54) **Architecture de mémoire à lignes d'écriture segmentées**

(30) Priorité: 16.06.2004 FR 0406532
(71) Demandeur: STMicroelectronics S.A., 92120 Montrouge (FR)
(72) Inventeur: Dray, Cyrille, 38320 Eybens (FR); Barasinski, Sébastien, 38240 Meylan (FR); Lasseuguette, Jean, 38000 Grenoble (FR); Frey, Christophe, Austin Texas 78727 (US); Fournel, Richard, 28660 Lumbin (FR)
(74) Mandataire: Bentz, Jean-Paul

(57) **Abrégé**

L'invention concerne un dispositif de mémoire, comprenant au moins une ligne d'écriture segmentée (10) formée d'au moins un segment d'écriture, dotée de moyens de programmation (90), lesdits moyens de programmation (90) étant commandés par des moyens d'adressage de ligne (190) en mode écriture dudit dispositif de mémoire, pour programmer au moins une cellule mémoire (30) couplée à ladite ligne d'écriture segmentée, une ligne de bit de lecture (150) étant reliée à un circuit de lecture (110) pour lire le contenu de ladite cellule en mode lecture dudit dispositif de mémoire, caractérisé en ce que ladite ligne de bit de lecture coopère en mode écriture avec lesdits moyens d'adressage de ligne pour commander lesdits moyens de programmation de ladite ligne d'écriture segmentée.

## Description

La présente invention concerne, de façon générale, le domaine des mémoires en circuit intégré et, plus particulièrement, des mémoires en circuit intégré présentant une architecture à lignes d'écriture segmentées. L'invention s'applique typiquement, mais non exclusivement, aux mémoires vives magnétiques de type MRAM présentant une telle architecture.

Plus précisément, l'invention concerne, selon un premier de ses aspects, un dispositif de mémoire, comprenant au moins une ligne d'écriture segmentée, dotée de moyens de programmation commandés par des moyens d'adressage de ligne en mode écriture du dispositif de mémoire, pour programmer au moins une cellule mémoire couplée à ladite ligne d'écriture segmentée, une ligne de bit de lecture étant reliée à un circuit de lecture pour lire le contenu de ladite cellule en mode lecture du dispositif de mémoire. Dans le contexte de la présente invention, on entend par ligne d'écriture segmentée, une ligne d'écriture formée d'au moins un segment d'écriture.

La description de l'invention qui suit étant faite en référence à une mémoire de type MRAM, quelques rappels sur son fonctionnement sont présentés ci-après.

Les mémoires vives magnétiques MRAM (acronyme anglo-saxon pour « Magnetic Random Access Memory ») sont des mémoires de type non volatile, où chaque cellule mémoire est formée d'une jonction tunnel magnétique. Ce type de mémoire présente tous les avantages combinés des mémoires à semiconducteurs actuellement existantes : rapidité tant à l'écriture qu'à la lecture, faible consommation, non-volatilité et insensibilité aux radiations. Ces atouts sont de plus combinés à une possibilité d'intégration accrue due à la faible taille des cellules.

Typiquement, un dispositif de mémoire vive magnétique comprend une matrice de cellules mémoire disposées en rangées et en colonnes, à travers laquelle sont acheminées des pistes métalliques dédiées à l'écriture et à la lecture. Les pistes métalliques d'écriture s'étendant le long des rangées de cellules mémoire sont appelées lignes d'écriture de mot et les pistes métalliques s'étendant le long des colonnes de cellules mémoire sont appelées lignes d'écriture de bit. Chaque cellule mémoire ainsi placée à l'intersection d'une ligne de mot et d'une ligne de bit mémorise un bit d'information sous forme d'orientation de magnétisation.

Dans l'architecture standard, l'adressage des cellules mémoires à l'écriture s'effectue donc à l'aide de champs magnétiques induits par un réseau matriciel de lignes métalliques soumises à des impulsions de courant, seule la cellule mémoire à l'intersection des deux lignes d'écriture sélectionnées devant se retourner. A la lecture, un courant de faible amplitude est envoyé par l'intermédiaire d'une ligne de bit de lecture et d'un transistor de commande CMOS par exemple, pour lire la résistance de la jonction. Il est à noter que dans ce type de mémoire, la circuiterie de lecture est au moins partiellement dissociée de la circuiterie d'écriture.

Chacune des cellules mémoire est en effet constituée de deux couches magnétiques, séparées par une couche diélectrique. Chaque couche magnétique possède une orientation propre de magnétisation. L'orientation de la magnétisation d'une des couches, dite couche libre, est modifiable, tandis que l'orientation de la magnétisation de l'autre couche, dite couche fixée, est fixe dans une orientation particulière. Les orientations de la magnétisation des deux couches peuvent se trouver dans deux situations : soit parallèles, c'est-à-dire alignées dans la même direction, soit anti-parallèles, c'est-à-dire alignées dans des directions opposées. Ces deux orientations, parallèle et anti-parallèle, représentent les valeurs logiques « 1 » et « 0 », respectivement. En variante, l'état parallèle peut être interprété comme un « 0 » logique et l'état anti-parallèle comme un « 1 » logique.

Dès lors, l'écriture pour une telle cellule mémoire consiste à positionner l'orientation de magnétisation dans la couche libre en fonction de l'état logique souhaité, dans un état soit parallèle, soit anti-parallèle, par rapport à l'orientation de magnétisation de la couche fixée.

Typiquement, des champs magnétiques externes sont appliqués sur une cellule sélectionnée pour basculer l'orientation de magnétisation dans la couche libre de cette cellule d'un état à un autre. Pour ce faire, un courant d'écriture est appliqué respectivement sur la ligne de mot et la ligne de bit d'écriture se coupant à l'emplacement de la cellule mémoire sélectionnée. Les courants d'écriture ainsi appliqués sur la ligne de mot et la ligne de bit sélectionnées créent des champs magnétiques qui, lorsqu'ils se combinent à l'intersection de la ligne de mot et de la ligne de bit, permettent de commuter l'orientation de magnétisation de la couche libre de la cellule mémoire sélectionnée de l'état parallèle à anti-parallèle, ou vice-versa, en fonction de la donnée qui doit être écrite dans la cellule.

Le basculement d'un état à un autre d'une cellule mémoire sélectionnée en écriture nécessite des champs magnétiques élevés, ce qui impose de faire circuler des courants d'écriture suffisamment forts, de l'ordre de la dizaine de milliampères, au niveau des pistes métalliques constituant les lignes d'écriture de mot et de bit à l'intersection desquelles se trouve la cellule mémoire sélectionnée en écriture.

Or, les pistes conductrices constituant les lignes d'écriture sont par nature résistives. Le fait de faire circuler un fort courant de l'ordre de la dizaine de milliampères sur une ligne d'écriture va donc inévitablement provoquer une chute du potentiel aux bornes de celle-ci, par application de la loi d'Ohm. Une tension d'alimentation relativement élevée est donc nécessaire au niveau des circuits de commande d'écriture pour compenser la chute de potentiel au travers des lignes d'écriture métalliques.

Cependant, les futures topologies de mémoire, répondant notamment à des contraintes d'intégration accrues, empêcheront l'utilisation de transistors haute tension pour les circuits de commande du courant d'écriture. Dans cette perspective, on cherche ainsi de plus en plus à converger vers une tension d'alimentation nominale unique, par exemple de l'ordre de 1,2 volt.

Dans ce contexte, on peut envisager une architecture de mémoire MRAM à lignes d'écriture de mot et/ou de bit segmentées. En effet, dans une telle architecture, telle que présentée par exemple dans le document de brevet US6,594,191, la pluralité de cellules mémoires est disposée en segments le long du plan mémoire. Les lignes d'écriture de bit et/ou de mot traversant le plan mémoire sont donc elles-mêmes segmentées, créant des chemins de courant d'écriture plus courts. Cette architecture implique donc une charge résistive équivalente des lignes d'écriture plus faible, autorisant ainsi une tension d'limentation nominale plus faible puisque les pertes de ligne sont moindres. Une telle architecture de ligne d'écriture segmentée permet également de minimiser la probabilité de basculement erroné de cellules mémoires non sélectionnées en écriture. En effet, seules les cellules mémoires sur le chemin du segment de ligne sélectionné en écriture seront alors soumises au champ magnétique généré par le passage du courant d'écriture sur le segment, au lieu de toute la rangée et/ou colonne de cellules mémoires.

Cependant, la mise en place d'une telle architecture avec des lignes d'écriture de mot et/ou de bit segmentées implique un certain nombre de contraintes, se rapportant notamment à l'adressage des différents segments de ligne d'écriture.

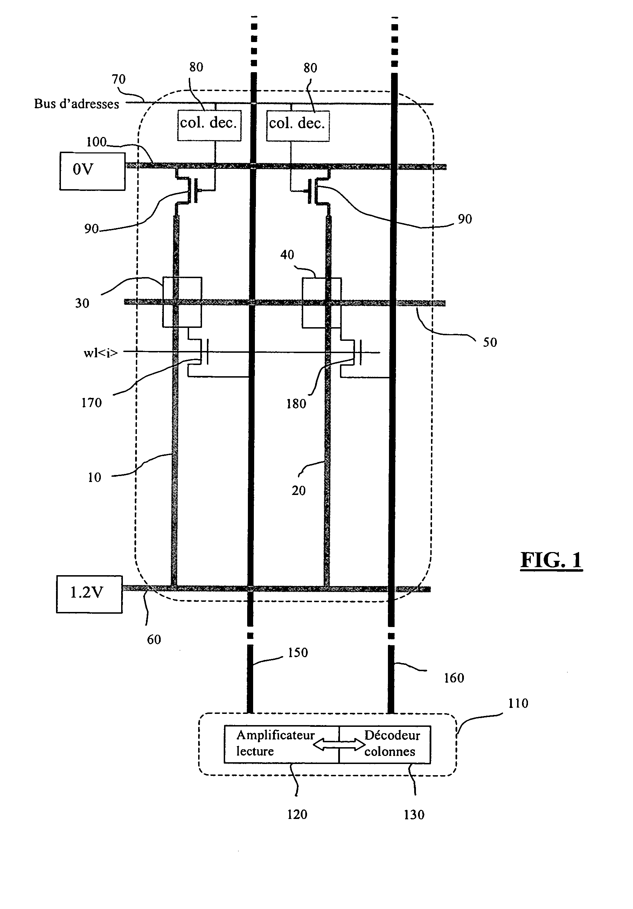

Pour illustrer ce propos, on se rapporte ici à la figure 1, décrivant de façon simplifiée une partie d'un plan mémoire de type MRAM selon une architecture matricielle à ligne d'écriture de bit segmentée. Un plan mémoire du type considéré comprend donc une pluralité de lignes d'écriture de bit segmentées et une pluralité de lignes d'écriture de mot organisées matriciellement selon une architecture colonne, typiquement 64, 128 ou 256 lignes, à l'intersection desquelles sont positionnées les cellules mémoires de type MRAM. Dans un souci de simplifier l'explication, on a représenté simplement deux colonnes et une rangée de cellules mémoires.

Ainsi, seuls deux segments de lignes d'écriture de bit 10 et 20, s'étendant le long de deux colonnes du plan mémoire, sont représentés avec leur circuiterie d'écriture associée. Deux cellules mémoire 30 et 40 sont disposées à l'intersection d'une ligne d'écriture de mot 50 et de chacun des segments de lignes d'écriture de bit 10 et 20. On pourrait envisager une architecture comprenant en outre des lignes d'écriture de mot segmentées. La circuiterie d'écriture associée aux segments de ligne d'écriture de bit qui va être décrite ci-après se retrouverait de manière similaire au niveau des segments de ligne de mot. La circuiterie de lecture associée comprenant les lignes de mot de lecture a notamment pour rôle de véhiculer l'information de décodage de ligne, qui peut être réutilisée à des fins d'écriture.

Tout d'abord, les segments de lignes d'écriture de bit 10 et 20 sont reliés par une de leur extrémité à une alimentation 60, par exemple 1,2 volt. Pour adresser une colonne en écriture parmi une pluralité, des moyens de décodage d'adresse de colonne sont prévus. Ces moyens sont constitués par un bus d'adresses 70, convoyant par exemple six signaux d'adresse de colonne dans le cas d'un plan mémoire comprenant 64 colonnes, associé à des circuits de décodage d'adresse 80 pour chaque colonne, réalisés en logique statique. La sortie de chaque circuit de décodage de colonne 80 est prévue pour piloter des moyens de programmation 90 associés au segment de ligne d'écriture de bit adressé. Ces moyens de programmation 90, assurant également la commutation du segment de ligne à la masse, sont représentés symboliquement par un transistor, dont la source est connectée à une ligne de masse 100, le drain est connecté au segment de ligne d'écriture 10 et la grille est commandée par la sortie du circuit de décodage de colonne 80.

Pour ce qui est de la circuiterie de lecture, elle est dissociée pour partie de la circuiterie d'écriture et nous y reviendrons plus en détail plus loin dans la description.

A ce stade, il convient tout d'abord de noter qu'une pluralité de segments de ligne d'écriture de bit non représentés, tels que le segment 10, est cascadée le long de chaque colonne du plan mémoire. Pour chaque segment de ligne d'écriture de bit cascadé, il est nécessaire de prévoir des moyens de programmation et il faudra donc obligatoirement prévoir les moyens de décodage d'adresse associés.

L'inconvénient majeur d'une telle architecture à ligne d'écriture segmentée réside donc dans la nécessaire redondance des moyens de décodage d'adresse à chaque occurrence de segment de ligne d'écriture, afin de pouvoir sélectionner un segment en écriture parmi la pluralité de segments.

Or, dans la perspective d'une architecture segmentée, et compte-tenu des exigences de design allant vers une densité accrue des mémoires, il n'est pas souhaitable de reproduire la logique spécifique de décodage d'adresse au niveau de tous les segments de ligne d'écriture, ces éléments étant en effet assez fortement consommateurs d'espace sur le plan mémoire.

La présente invention a pour but de remédier aux inconvénients précédemment cités, en proposant un dispositif de mémoire à lignes d'écriture segmentées, dans lequel l'adressage en écriture des différents segments de ligne d'écriture ne conduit pas à une surcharge des moyens de décodage d'adresse de ligne, et qui ne soit pas pénalisant en termes de densité du plan mémoire.

A cette fin, l'invention, concerne un dispositif de mémoire, comprenant au moins une ligne d'écriture segmentée formée d'au moins un segment d'écriture, dotée de moyens de programmation, lesdits moyens de programmation étant commandés par des moyens d'adressage de ligne en mode écriture dudit dispositif de mémoire, pour programmer au moins une cellule mémoire couplée à ladite ligne d'écriture segmentée, une ligne de bit de lecture étant reliée à un circuit de lecture pour lire le contenu de ladite cellule en mode lecture dudit dispositif de mémoire, caractérisé en ce que ladite ligne de bit de lecture coopère en mode écriture avec lesdits moyens d'adressage de ligne pour commander lesdits moyens de programmation de ladite ligne d'écriture segmentée.

Selon une caractéristique de l'invention, les lignes d'écriture segmentées comprennent des lignes d'écriture de bit.

Selon un mode de réalisation préféré, le dispositif de mémoire est organisé matriciellement en lignes d'écriture de bit et en lignes d'écriture de mot, les cellules mémoires étant positionnées à l'intersection desdites lignes d'écriture.

Dans une variante, les lignes d'écriture de mot sont également segmentées.

Avantageusement, le circuit de lecture comprend des moyens de sélection de colonne, et des moyens pour faire circuler en mode écriture l'information de sélection de colonne sur la ligne de bit de lecture à destination des moyens d'adressage des moyens de programmation associés à la ligne d'écriture segmentée.

Selon un mode de réalisation, les moyens d'adressage des moyens de programmation associés à la ligne d'écriture segmentée, comprennent une ligne de sélection véhiculant une information de sélection de segment et un moyen de combinaison logique dont une première entrée est connectée à ladite ligne de sélection de segment, une seconde entrée est connectée à la ligne de bit de lecture et dont la sortie est prévue pour activer lesdits moyens de programmation associés à ladite ligne d'écriture segmentée.

Selon un mode de réalisation particulier, la ligne de bit de lecture comprend une ligne de bit de lecture globale connectée à au moins une ligne de bit de lecture intermédiaire par l'intermédiaire de moyens de sélection de lignes de bit de lecture intermédiaire, ladite ligne de bit de lecture intermédiaire accédant en lecture à la cellule mémoire par l'intermédiaire d'un transistor d'accès de la cellule.

De préférence, la ligne de bit de lecture globale est commune à deux colonnes du dispositif de mémoire, ladite ligne de bit de lecture globale étant connectée à deux lignes de bit de lecture intermédiaires pour l'accès en lecture respectivement à chacune des deux colonnes.

De préférence, les cellules mémoires sont de type MRAM.

L'invention concerne encore un circuit intégré comprenant un dispositif de mémoire tel qu'il vient d'être décrit.

D'autres caractéristiques et avantages de la présente invention apparaîtront plus clairement à la lecture de la description suivante, donnée à titre d'exemple illustratif et non limitatif et faite en référence aux figures annexées dans lesquelles :
- la figure 1, déjà décrite, montre une partie d'un plan mémoire de type MRAM selon une architecture matricielle à ligne d'écriture de bit segmentée, illustrant le problème que se propose de résoudre la présente invention ;
- la figure 2 est un schéma illustrant un mode de réalisation du dispositif de mémoire selon la présente invention ;
- la figure 3 est une variante du dispositif de mémoire selon la présente invention, dans laquelle une circuiterie de lecture avec lignes de bit globales et intermédiaires est mise en oeuvre.

Revenons à la figure 1, pour s'intéresser maintenant plus précisément aux moyens de lecture des cellules mémoire du plan mémoire. Selon l'exemple de réalisation de la figure 1, pour chaque colonne du plan mémoire, il est prévu une ligne de bit de lecture associée, respectivement 150 et 160, constituée par une piste métallique destinée à véhiculer un courant de lecture. Chaque ligne de bit de lecture a la particularité de parcourir tout le plan mémoire. Une ligne de mot de lecture véhiculant un signal wl<i> est utilisée pour sélectionner en lecture la rangée de cellules mémoires, comprenant notamment les cellules 30 et 40 représentées, par l'intermédiaire de transistors d'accès en lecture, respectivement 170 et 180. L'utilisation simultanée de la ligne de bit 150 par exemple, permet de conduire un courant de lecture à travers la cellule mémoire sélectionnée 30 par l'intermédiaire du transistor d'accès 170 rendu actif par un signal à l'état haut appliqué sur la ligne de mot de sélection wl<i>.

Pour ce faire, chaque ligne de bit de lecture 150, 160 est reliée à une de ses extrémités à un circuit de lecture 110, formé d'un amplificateur de lecture 120 associé à des moyens de décodage de colonne 130, permettant de sélectionner une colonne en lecture parmi une pluralité de colonnes.

Il ressort donc de ce qui précède que les ressources matérielles mises en oeuvre en mode de lecture sont en grande partie complètement dissociées des ressources matérielles mises en oeuvre en mode d'écriture de la mémoire. De plus, les moyens de lecture sont confrontés à une même problématique que les moyens d'écriture, concernant le décodage d'une colonne du plan mémoire parmi une pluralité de colonnes. La présente invention vise donc à tirer avantage du fait que les moyens de lecture incorporent déjà des moyens de décodage de colonnes 130 au niveau du circuit de lecture 110, autorisant de sélectionner une colonne parmi une pluralité de colonnes pour la lecture.

Aussi, dans un contexte d'architecture à lignes d'écriture segmentées, et plus particulièrement à lignes de bit segmentées, le concept de l'invention consiste-t-il à réutiliser des ressources matérielles déjà présentes au sein du plan mémoire et normalement dévolues à la lecture de sorte à éviter la redondance des moyens de décodage d'adresse des cellules sélectionnées en écriture au niveau de chaque occurrence de segment de ligne d'écriture de bit. Il est à noter que le concept de la présente invention s'appliquerait tout aussi bien à une architecture où les lignes d'écriture seraient formées d'un seul segment d'écriture, revenant à considérer des lignes non segmentées.

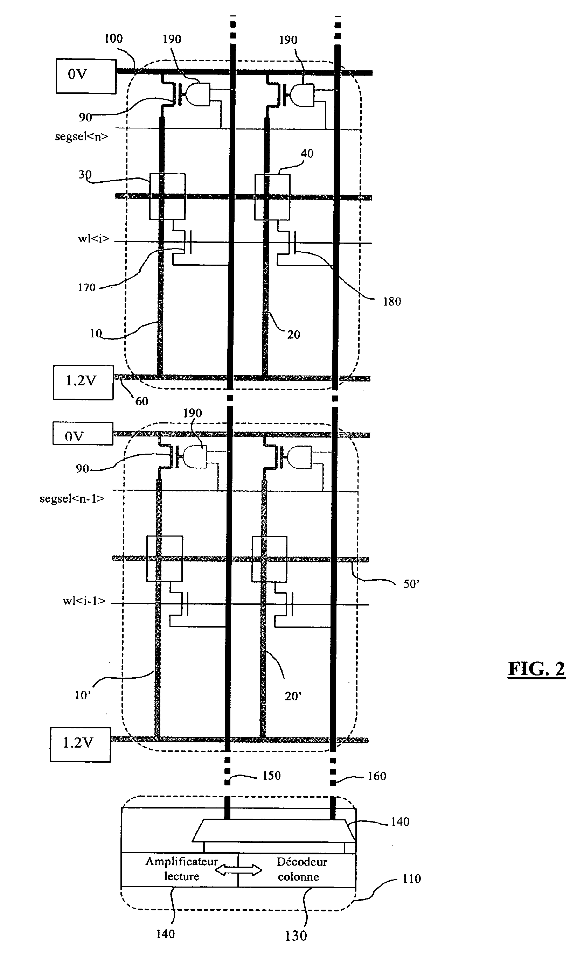

La figure 2 illustre à cet effet un mode de réalisation du dispositif de mémoire selon la présente invention. Les éléments en commun avec la figure 1 gardent les mêmes références. Sur la figure 2, on a représenté cette fois deux colonnes et deux rangée de cellules mémoires, chacune appartenant à un segment d'écriture différent.

Ainsi, deux segments de lignes d'écriture de bit supplémentaires 10' et 20', s'étendant le long des deux colonnes représentées du plan mémoire, sont cascadées avec leur moyen de programmation en écriture associé 90. Deux cellules mémoire sont donc disposées à l'intersection respectivement d'une ligne d'écriture de mot 50' et de chacun des segments de lignes d'écriture de bit cascadés 10' et 20'.

Selon l'invention, on va mettre à profit les moyens de sélection de colonne 130 du circuit de lecture 110, fournissant un signal de décodage d'adresse colonne normalement dévolu à la sélection en lecture d'une colonne parmi une pluralité de colonnes, ainsi que la ressource métallique que sont les lignes de bit de lecture, pour permettre l'adressage en écriture des moyens de programmation 90 associés à un segment de ligne d'écriture. On réutilise donc les moyens de décodage colonne du circuit de lecture à des fins d'écriture et la ligne de bit de lecture est quant à elle utilisée pour convoyer l'information de sélection de colonne à destination de la circuiterie d'écriture.

Prenons un exemple où l'on souhaite adresser en écriture les moyens de programmation 90 associés à la ligne d'écriture de bit segmentée 10, pour programmer la cellule 30. Un signal d'adresse adéquat, généré par les moyens de sélection de colonne 130, est donc envoyé sur la ligne de bit de lecture 150 correspondant à la colonne que l'on souhaite sélectionner en écriture, par l'intermédiaire de moyens 140 prévus à cet effet au sein du circuit de lecture 110 et auxquels l'ensemble des lignes de bit de lecture sont connectées. Ces moyens 140, représentés symboliquement par un multiplexeur sur la figure 2 permettent, soit de sélectionner la ligne de bit de lecture en mode lecture, soit de convoyer l'information de sélection de colonne sur la ligne de bit de lecture.

L'information de sélection de colonne, ainsi véhiculée par la ligne de bit de lecture 150, permet alors de sélectionner l'ensemble des segments de ligne d'écriture de bit 10, 10', associé à la colonne considérée.

Le dispositif de mémoire selon l'invention comprend en outre une ligne de sélection de segment propre à chaque segment du dispositif. La ligne de sélection de segment véhiculant un signal segsel<n> pour le segment considéré traverse donc le plan mémoire selon l'axe horizontal et est prévue pour convoyer une information supplémentaire de sélection de segment. Si l'on souhaite adresser également en écriture les moyens de programmation 90 du segment de ligne d'écriture 10', il convient alors d'activer en outre la ligne de sélection de segment segsel<n-1>.

L'information supplémentaire de sélection de segment ainsi convoyée, en combinaison avec l'information de sélection de colonne convoyée par la ligne de bit de lecture 150, autorise alors d'adresser en écriture les moyens de programmation 90 du segment de ligne d'écriture 10.

Pour ce faire, une porte logique 190, typiquement une porte logique de type ET, propre à chaque segment de ligne d'écriture de bit, comprend une première entrée connectée à la ligne de sélection de segment segsel<n>, une second entrée connectée à la ligne de bit de lecture 150 et une sortie connectée aux moyens de programmation 90 associés à la ligne d'écriture de bit segmentée 10 adressée en écriture. La combinaison des signaux par la porte logique 190 permet donc d'activer les moyens de programmation 90 du segment de ligne d'écriture voulu.

L'intérêt des moyens d'adressage en écriture des lignes de bit d'écriture segmentées mis en oeuvre dans le dispositif de mémoire selon la présente invention, est notamment qu'ils ne nécessitent qu'une seule porte logique 190 en lieu et place de la pluralité de portes logiques impliquées par les circuits de décodage de colonne référencés 80 à la figure 1. De plus, un seul signal horizontal par segment, segsel<n>, est rendu nécessaire pour réaliser l'adressage en écriture.

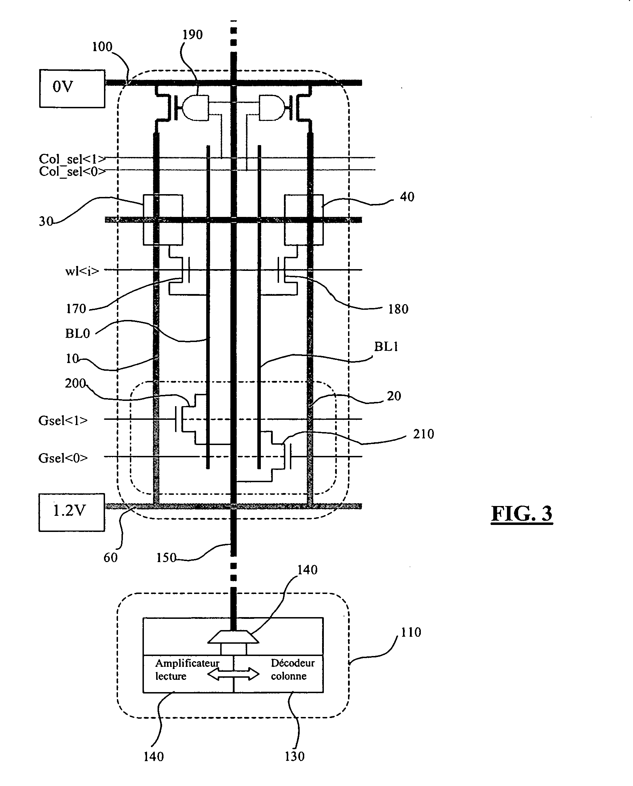

La figure 3 décrit enfin un mode de réalisation particulier du dispositif de mémoire selon la présente invention, dans lequel la circuiterie de lecture est modifiée, plus particulièrement en ce qui concerne les chemins d'accès en lecture aux cellules mémoire. Ainsi, selon ce mode de réalisation, la ligne de bit de lecture 150 est une ligne de bit de lecture globale, parcourant tout le plan mémoire, et reliée à des lignes de bit de lecture intermédiaires. Selon un mode de réalisation, une ligne de bit de lecture globale est par exemple commune à deux colonnes du plan mémoire et est alors prévue pour être reliée à deux lignes de bit de lecture intermédiaires BL0, BL1, pour l'accès en lecture à chaque colonne respectivement. La liaison entre la ligne de bit de lecture globale et les lignes de bit de lecture intermédiaires est réalisée par l'intermédiaire de transistors de sélection de groupe 200, 210 commandés par les signaux Gsel. La ligne de bit intermédiaire BL0 permet ainsi d'accéder en lecture à la cellule mémoire 30 par l'intermédiaire du transistor d'accès 170 et la ligne de bit intermédiaire BL1 permet d'accéder en lecture à la cellule mémoire 40 par l'intermédiaire du transistor d'accès 180.

L'intérêt de cette architecture de lecture est que l'ensemble des points mémoires d'une colonne n'est plus connecté directement à la ligne de bit de lecture globale, ce qui permet de minimiser les charges capacitives sur la ligne de bit de lecture globale et donc d'améliorer les performances en terme de vitesse.

Ainsi, pour lire le contenu de la cellule 30 par exemple, on sélectionne d'abord la ligne de lecture globale 150, puis on active le transistor de sélection 200 autorisant l'accès à la ligne de bit intermédiaire BL0 par l'intermédiaire du signal Gsel<1> et ensuite, on sélectionne l'accès à la cellule 30 en activant le transistor d'accès 170 par l'intermédiaire du signal wl<i>. Pendant cette opération de lecture, l'accès à la ligne de bit de lecture intermédiaire BL1 est fermé, un signal Gsel<0> étant appliqué sur la grille du transistor de sélection correspondant 210.

Pour ce qui concerne l'adressage en écriture des moyens de programmation d'un segment de ligne d'écriture de bit, l'information de décodage colonne est convoyée par la ligne de bit de lecture globale 150 à destination de la circuiterie d'écriture. Toutefois, lors d'une telle utilisation des ressources de lecture en mode d'écriture, il est nécessaire que les chemins d'accès aux lignes de bit intermédiaires d'une part, puis aux cellules d'autre part, soient fermés.

Dans l'exemple, on a une ligne de bit globale commune à deux colonnes. L'information de sélection de colonne véhiculée par la ligne de bit de lecture globale 150 permet alors de sélectionner en écriture l'ensemble des segments de ligne d'écriture de bit, notamment 10 et 20, associé à chacune des deux colonnes respectivement. Dans cette configuration, pour le segment considéré, la porte logique 190 associée à chaque ligne d'écriture de bit segmentée 10, 20 voit donc une de ses entrées connectée à la ligne de bit de lecture globale 150. Pour pouvoir adresser en écriture l'une ou l'autre ligne segmentée, l'autre entrée de chaque porte logique 190 associée à chaque ligne d'écriture de bit segmentée 10, 20 doit alors être connectée sur une ligne de sélection horizontale différente, respectivement Col_sel<1> et Col_sel<0>, de façon à sélectionner une colonne parmi les deux adressées.

Le concept de la présente invention a été décrit plus particulièrement en référence à une mémoire de type MRAM, mais pourrait en fait s'appliquer de manière non limitative à tous types de mémoire en circuit intégré présentant une architecture à ligne d'écriture segmentée formée d'au moins un segment d'écriture et comprenant des chemins d'écriture et de lecture dissociés.

## Revendications

1. Dispositif de mémoire, comprenant au moins une ligne d'écriture segmentée (10) formée d'au moins un segment d'écriture, dotée de moyens de programmation (90), lesdits moyens de programmation (90) étant commandés par des moyens d'adressage de ligne (190) en mode écriture dudit dispositif de mémoire, pour programmer au moins une cellule mémoire (30) couplée à ladite ligne d'écriture segmentée, une ligne de bit de lecture (150) étant reliée à un circuit de lecture (110) pour lire le contenu de ladite cellule en mode lecture dudit dispositif de mémoire, **caractérisé en ce que** ladite ligne de bit de lecture coopère en mode écriture avec lesdits moyens d'adressage de ligne pour commander lesdits moyens de programmation de ladite ligne d'écriture segmentée.

2. Dispositif selon la revendication 1, **caractérisé en ce que** les lignes d'écriture segmentées comprennent des lignes d'écriture de bit.

3. Dispositif de mémoire selon la revendication 1 ou 2, **caractérisé en ce qu'**il est organisé matriciellement en lignes d'écriture de bit et en lignes d'écriture de mot, les cellules mémoires étant positionnées à l'intersection desdites lignes d'écriture.

4. Dispositif de mémoire selon la revendication 3, **caractérisé en ce que** les lignes d'écriture de mot sont segmentées.

5. Dispositif de mémoire selon la revendication 3 ou 4, **caractérisé en ce que** le circuit de lecture (110) comprend des moyens de sélection de colonne (130), et des moyens (140) pour faire circuler en mode écriture l'information de sélection de colonne sur la ligne de bit de lecture à destination des moyens d'adressage (190) des moyens de programmation (90) associés à la ligne d'écriture segmentée.

6. Dispositif de mémoire selon l'une quelconque des revendications 1 à 5, **caractérisé en ce que** les moyens d'adressage des moyens de programmation (90) associés à la ligne d'écriture segmentée (10), comprennent une ligne de sélection (segsel, Col_sel) véhiculant une information de sélection de segment et un moyen de combinaison logique (190) dont une première entrée est connectée à ladite ligne de sélection de segment, une seconde entrée est connectée à la ligne de bit de lecture (150) et dont la sortie est prévue pour activer lesdits moyens de programmation (90) associés à ladite ligne d'écriture segmentée (10).

7. Dispositif de mémoire selon l'une quelconque des revendications précédentes, **caractérisé en ce que** la ligne de bit de lecture comprend une ligne de bit de lecture globale (150) connectée à au moins une ligne de bit de lecture intermédiaire (BLO) par l'intermédiaire de moyens de sélection de lignes de bit de lecture intermédiaire (200), ladite ligne de bit de lecture intermédiaire accédant en lecture à la cellule mémoire par l'intermédiaire d'un transistor d'accès (170) de la cellule.

8. Dispositif de mémoire selon les revendications 3 et 7, **caractérisé en ce que** la ligne de bit de lecture globale est commune à deux colonnes du dispositif de mémoire, ladite ligne de bit de lecture globale étant connectée à deux lignes de bit de lecture intermédiaires (BL0, BL1) pour l'accès en lecture respectivement à chacune des deux colonnes.

9. Dispositif de mémoire selon l'une quelconque des revendications précédentes, **caractérisé en ce que** les cellules mémoires sont de type MRAM.

10. Circuit intégré comprenant un dispositif de mémoire selon l'une quelconque des revendications précédentes.
